Europäisches Patentamt

European Patent Office

Office européen des brevets

(19)

(11) **EP 0 795 042 B1**

(12) **FASCICULE DE BREVET EUROPEEN**

(45) Date de publication et mention de la délivrance du brevet:
**04.11.1998 Bulletin 1998/45**

(51) Int Cl.6: **C23C 16/40**, C23C 16/44, C23C 16/02, G21C 3/00

(21) Numéro de dépôt: **95941160.4**

(22) Date de dépôt: **29.11.1995**

(86) Numéro de dépôt international:
**PCT/FR95/01576**

(87) Numéro de publication internationale:
**WO 96/17105 (06.06.1996 Gazette 1996/26)**

(54) **Procédé de revêtement d'un substrat en métal ou alliage passivable par une couche d'oxyde**

Verfahren zur Beschichtung eines passivierbaren Subtrates aus einem Metall oder einer Legierung mit einer Oxidschicht

Process for coating with an oxide layer a passivable metal or alloy substrate

(84) Etats contractants désignés:
**BE DE ES FR GB SE**

(30) Priorité: **01.12.1994 FR 9414466**

(43) Date de publication de la demande:
**17.09.1997 Bulletin 1997/38**

(73) Titulaires:
- **FRAMATOME**
  **92400 Courbevoie (FR)**
- **COGEMA**
  **F-78141 Velizy Villacoublay (FR)**

(72) Inventeurs:
- **HERTZ, Dominique**
  **F-69110 Saint-Foy-lès-Lyon (FR)**
- **BELMONTE, Thierry**
  **F-54600 Villers-les-Nancy (FR)**
- **GAVILLET, Jérôme**
  **F-54000 Nancy (FR)**
- **MICHEL, Henri**
  **F-54500 Vandoeuvre-les-Nancy (FR)**

(74) Mandataire: **Bouget, Lucien et al**
**Cabinet Lavoix**
**2, Place d'Estienne d'Orves**
**75441 Paris Cédex 09 (FR)**

(56) Documents cités:
**EP-A- 0 022 349**       **US-A- 4 239 819**

- **JOURNAL OF THE CERAMIC SOCIETY OF JAPAN, MAY 1993, JAPAN, vol. 101, no. 5, ISSN 0914-5400, pages 502-505, KUMASHIRO Y ET AL 'Low temperature preparation of TiO/sub 2/ thin films by plasma-enhanced chemical vapor deposition'**
- **THIN SOLID FILMS, 15 SEPT. 1994, SWITZERLAND, vol. 249, no. 2, ISSN 0040-6090, pages 163-167, CAO C -B ET AL 'Research on YSZ thin films prepared by plasma-CVD process'**
- **JOURNAL OF MATERIALS SCIENCE: MATERIALS IN ELECTRONICS, JUNE 1992, UK, vol. 3, no. 2, ISSN 0957-4522, pages 87-92, JOON-HOO CHOI ET AL 'Effects of the reaction parameters on the deposition characteristics in ZrO/sub 2/ CVD'**
- **APPLIED PHYSICS LETTERS, 27 JAN. 1992, USA, vol. 60, no. 4, ISSN 0003-6951, pages 434-436, YASUDA T ET AL 'Low-temperature preparation of SiO/sub 2//Si(100) interfaces using a two-step remote plasma-assisted oxidation-deposition process'**

EP 0 795 042 B1

## Description

L'invention concerne un procédé de revêtement d'un substrat en un métal passivable ou en un alliage à base de métal passivable, tel que le zirconium, par une couche d'oxyde métallique.

Les crayons de combustible des réacteurs nucléaires à eau sous pression sont constitués par des pastilles d'un matériau combustible nucléaire sous forme d'oxyde empilées à l'intérieur d'une gaine tubulaire généralement en un alliage de zirconium. Les gaines des crayons de combustible doivent assurer le maintien des pastilles de combustible nucléaire et constituent la première barrière s'opposant à la dissémination du combustible nucléaire, à l'intérieur du réacteur.

Dans le cas d'un percement local de la gaine d'un crayon de combustible, l'eau de refroidissement du réacteur pénètre à l'intérieur de la gaine du crayon de combustible ; cette eau qui entre en ébullition réagit avec le métal de la gaine pour former de l'hydrogène qui produit une hydruration du métal de la gaine. Il peut en résulter de nouvelles perforations de la gaine qui amplifient les effets du percement initial.

Il est donc nécessaire de réduire au maximum les risques de percement des gaines de crayons de combustible, en particulier au niveau de la grille inférieure des assemblages où les crayons sont soumis à des écoulements hydrauliques transversaux intenses et sont donc susceptibles de s'user, du fait du phénomène de «fretting», par mise en vibration contre les supports de crayons constitués par les ressorts et les bossettes.

En outre, la grille inférieure d'un assemblage de combustible nucléaire est un endroit privilégié de piégeage de débris qui sont mis en vibration par le fluide de refroidissement en circulation. Ces débris mis en vibration peuvent dégrader les crayons par frottement et usure.

On a donc proposé de protéger les gaines de crayons de combustible par une couche de revêtement résistant à l'usure, en particulier dans les zones de la gaine les plus exposées à l'usure.

On a, par exemple, proposé d'améliorer la résistance à l'usure des gaines de crayons de combustible en alliage de zirconium par dépôt de revêtement dur sur la surface extérieure des gaines et en particulier par des dépôts d'oxyde de zirconium (zircone), ces dépôts pouvant assurer une certaine protection contre l'usure par les débris transportés par l'eau de refroidissement du réacteur.

Dans le EP-A-0.421.868 déposé par les sociétés FRAMATOME et COGEMA, on a proposé un procédé d'oxydation superficielle d'une pièce en un métal passivable tel que le zirconium ou un alliage de zirconium qui permet de réaliser sur cette pièce une couche diffusée d'oxyde de zirconium. Ce procédé est applicable en particulier au revêtement de la surface extérieure des gaines de crayons combustibles pour réacteur nucléaire.

Dans le cadre de ce procédé d'oxydation superficielle d'une pièce en métal passivable, on utilise un gaz activé par un plasma froid, c'est-à-dire un gaz contenant des espèces activées par apport d'énergie. L'utilisation d'un gaz activé permet d'obtenir une couche d'oxyde composée de grains fins et homogènes à la surface de la pièce à des températures modérées.

Ce procédé permet d'obtenir des couches de revêtement en oxyde assurant une bonne protection contre la corrosion d'éléments tels que des tubes de gainage ; toutefois, les couches obtenues qui sont minces n'assurent pas une protection très efficace contre des dégradations d'origine mécanique provenant par exemple du frottement de débris contre les tubes de gainage.

On a également proposé dans le WO-A-92-09716 de réduire l'usure des tubes de gainage en alliage de zirconium par "fretting" en réalisant des revêtement de carbure ou d'oxyde sur la surface des tubes de gainage, en utilisant une phase gazeuse ou des sels fondus à une température inférieure à 500°C. On a pu former ainsi des couches protectrices dont l'épaisseur peut atteindre 2 μm. Les couches formées sur la surface des tubes de gainage sont encore trop minces pour permettre d'assurer une protection très efficace contre les dégradations mécaniques, par exemple pour éviter des rayures de la surface des tubes de gainage.

On a également proposé dans le US-A-5.171.520 de réaliser un revêtement local des crayons de combustible nucléaire dans les zones les plus soumises à l'usure, par projection sur la surface à revêtir de céramique et de verre. On peut obtenir ainsi des couches d'une épaisseur supérieure à 100 μm en des matériaux tels que le zircon liés par des alumino-silicates, des borosilicates ou des calcio-borates.

On a également proposé dans le US-A-5.227.129 de réaliser le revêtement de protection contre l'usure et contre la corrosion en nitrure de zirconium, sur la surface extérieure des tubes de gainage de crayons de combustible, par une méthode de dépôt ionique.

Bien que les procédés de protection par dépôt d'un revêtement permettent d'accroître sensiblement la résistance à l'usure des tubes de gainage de crayons de combustible, les revêtements obtenus présentent l'inconvénient d'être des couches formées par diffusion d'un élément, si bien que l'épaisseur de ces couches est limitée et qu'on produit de forts gradients de contrainte dans les couches superficielles revêtues. Dans le cas où l'on réalise des revêtements d'une certaine épaisseur, ces revêtements peuvent présenter des défauts qui conduisent à une sensibilisation à la corrosion du métal du substrat au droit de ces défauts.

D'autre part, les procédés de revêtement qui peuvent être utilisés dans le cas des crayons de combustible comportant un tube de gainage en alliage de zirconium doivent être réalisés à une température telle que l'état métallographique du tube de gainage ne soit pas modifié par le traitement.

Dans le cas d'un alliage de zirconium ayant subi un recuit de détente, les traitements doivent être effectués à une température inférieure à 480°C.

Dans le cas d'un alliage de zirconium à l'état recristallisé, le traitement doit être effectué à une température inférieure à 650°C.

On connaît des procédés de revêtement chimiques en phase gazeuse généralement appelés procédés CVD (Chemical Vapor Deposition) qui permettent de réaliser des dépôts de différentes natures sur un substrat. Pour la mise en oeuvre de ce procédé, on fait réagir à la surface du substrat à revêtir un gaz réactif, par exemple un gaz oxydant ou carburant, sur un composé volatil d'élément métallique, pour former en phase vapeur un composé de l'élément métallique tel qu'un oxyde ou carbure qui est déposé sur le substrat à revêtir.

En particulier, l'élément métallique peut être l'élément métallique de base du matériau constituant le substrat.

Dans le cas d'un tube de gainage en alliage de zirconium, il est possible de déposer, par exemple, un composé constitué par un oxyde de zirconium sur le substrat en alliage à base de zirconium.

Pour réaliser le dépôt du revêtement sur le substrat, il est nécessaire de porter le substrat à une température suffisamment élevée de l'ordre de 700 à 1100°C.

Dans le cas d'un tube de gainage en alliage de zirconium, la température de dépôt par le procédé CVD ne doit pas dépasser les limites fixées par la structure métallographique de l'alliage.

On connaît des procédés de dépôt CVD dans lesquels une partie de l'énergie nécessaire à l'activation de la réaction est apportée par une excitation du gaz réactif par un plasma à froid. L'excitation du gaz réactif permet de créer des espèces chimiques activées à l'intérieur du gaz qui présente ainsi un réactivité accrue.

On peut ainsi abaisser la température de réaction, ce qui est tout-à-fait favorable dans le cas de certaines applications.

Par ailleurs, on ne connaissait pas de procédé permettant de réaliser un revêtement très adhérent d'une couche d'oxyde métallique sur un substrat constitué principalement par un métal sensible à l'attaque par les halogénures et l'hydrogène.

Le but de l'invention est donc de proposer un procédé de revêtement d'un substrat en un métal passivable ou en un alliage à base d'un métal passivable, tel que le zirconium, par une couche d'oxyde métallique, ce procédé permettant d'obtenir un revêtement protecteur du substrat contre des dégradations mécaniques qui soit parfaitement adhérent, qui ne présente pas de risque d'accélération de corrosion au droit d'éventuels défauts et qui puisse être obtenu à une température modérée compatible avec les possibilités de traitement du substrat.

Dans ce but :

- on réalise une préoxydation superficielle du substrat par mise en contact, avec un gaz oxydant excité dans un plasma froid, du substrat placé dans la post-décharge en écoulement du plasma et porté à une température d'oxydation inférieure à 500°, et

- on réalise sur le substrat placé dans la post-décharge en écoulement du plasma, un dépôt d'oxyde métallique par oxydation d'un halogénure métallique, en mettant en contact l'halogénure métallique sous forme gazeuse avec un mélange gazeux réactif comportant un élément oxydant excité dans un plasma froid.

Le procédé de l'invention peut s'appliquer au revêtement d'un tube de gainage en alliage de zirconium d'un crayon combustible d'un assemblage d'un réacteur nucléaire ou d'une grille-entretoise de maintien de crayons dans un assemblage, comportant un revêtement protecteur en oxyde réalisé par le procédé de l'invention.

L'invention peut également s'appliquer au revêtement de la surface intérieure de tubes de guidage d'une grappe de crayons absorbants dans un assemblage de combustible.

L'activation des espèces réactives et en particulier des éléments oxydants utilisés dans le cadre de l'invention par un plasma froid permet, en apportant de l'énergie aux espèces réactives, de diminuer la température de réaction. Cette activation peut se faire en particulier en utilisant un plasma diode ou triode, un plasma radio-fréquence, un plasma micro-onde. La pression de travail dépend du type de plasma choisi. Pour obtenir un bon compromis entre les exigences relatives à la densité des espèces activées, la mise en oeuvre technologique et la souplesse du procédé, on utilise de préférence un système de générateur micro-onde de 300 à 2450 MHz.

On peut utiliser tout dispositif à cavité résonante pour transmettre les micro-ondes au gaz réactif.

De préférence, on élabore l'halogénure métallique gazeux par réaction d'un halogène sur un métal sous forme divisée porté à une température de réaction déterminée, au cours du processus de revêtement. Ainsi, la production d'halogénure gazeux peut être réglée en fonction des quantités nécessaires pour réaliser le revêtement du substrat.

Le substrat est disposé généralement dans la lointaine post-décharge en écoulement du plasma froid, c'est-à-dire dans une zone éloignée de la zone d'activation du plasma, de manière à être balayé par le gaz activé provenant de la zone d'activation. On peut ainsi réaliser un revêtement homogène sur des substrats étendus dans au moins une direction tels que des tubes de gainage de crayons combustibles de grande longueur. La disposition du substrat dans la lointaine post-décharge permet de régler l'activité du gaz réactif, du fait de la durée de vie limitée des espèces activées.

Afin de bien faire comprendre l'invention, on va maintenant décrire, à titre d'exemple non limitatif, en se référant à la figure jointe en annexe, un mode de réalisation d'un procédé suivant l'invention pour effectuer le revêtement par une couche de zircone d'un tube de gainage d'un crayon de combustible pour réacteur nucléaire en alliage de zirconium.

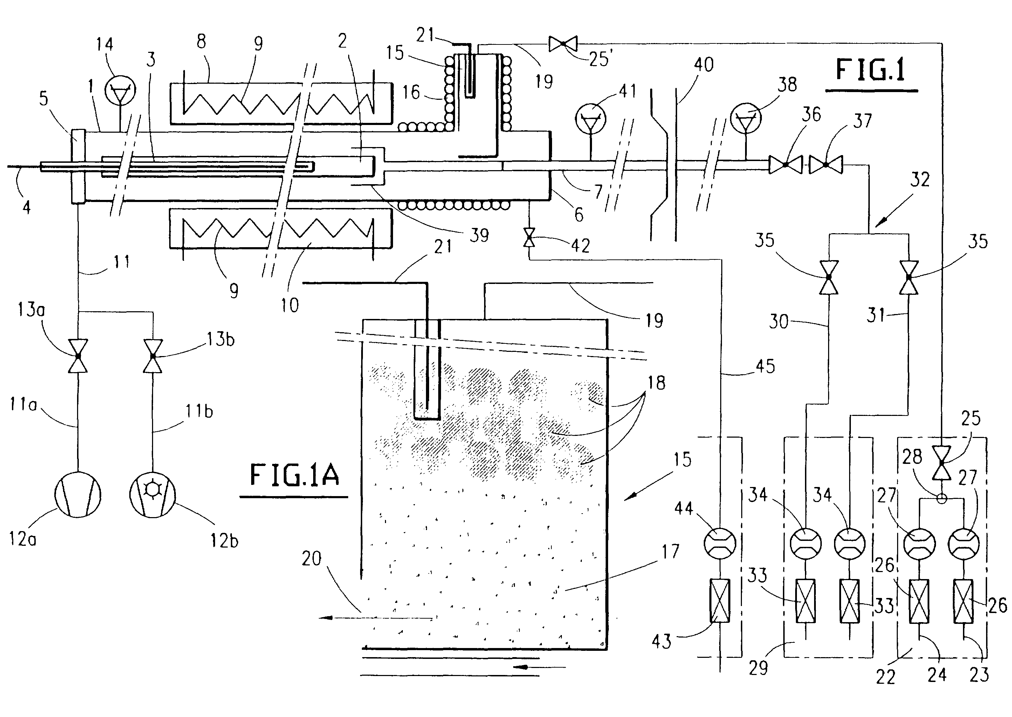

La figure 1 est une représentation schématique en élévation et en coupe d'un exemple de réalisation d'une installation pour la mise en oeuvre du procédé de revêtement suivant l'invention.

La figure 1A est une vue à plus grande échelle et en coupe de la chambre de chloration de l'installation représentée sur la figure 1.

Les deux phases du procédé de revêtement suivant l'invention, c'est-à-dire la phase de préoxydation du substrat en alliage de zirconium et la phase consécutive de dépôt en phase vapeur de zircone sur le substrat préoxydé sont réalisées l'une à la suite de l'autre, en utilisant le dispositif représenté sur la figure.

Le dispositif de revêtement comporte un tube réacteur 1 à l'intérieur duquel est disposé, de manière sensiblement coaxiale, un tube de gainage 2 d'un crayon de combustible d'un réacteur nucléaire à eau sous pression.

Le tube de gainage 2 est réalisé en un alliage de zirconium tel que le Zircaloy 4. Le tube de gainage 2 présente un diamètre de l'ordre de 10 mm et une longueur de l'ordre de 4 m.

Une partie du tube 2 sur laquelle on ne réalise pas de revêtement peut se trouver en saillie à l'extérieur du tube réacteur 1.

Le tube réacteur 1 présente un diamètre intérieur sensiblement supérieur au diamètre du tube de gainage 2 et une longueur qui peut être supérieure à la longueur du tube de gainage 2 du crayon de combustible.

Le tube de gainage 2 est maintenu à l'intérieur du tube réacteur 1, dans une disposition sensiblement coaxiale au tube réacteur, par l'intermédiaire d'un support 3 de forme tubulaire à l'intérieur duquel est disposé un thermocouple 4 permettant de mesurer la température du tube de gainage 2 pendant les différentes phases du procédé de revêtement.

Le support tubulaire 3 du tube de gainage 2 est fixé dans une ouverture centrale d'une platine 5 de fermeture d'une extrémité du tube réacteur. La platine 5 comporte des moyens de fixation amovibles et étanches sur la partie d'extrémité du tube réacteur 1, de manière à assurer le montage du tube de gainage 2 dans une disposition coaxiale, avant de démarrer une opération de revêtement.

L'extrémité du tube réacteur 1 opposée à la platine 5 est fermée par un fond 6 comportant une ouverture centrale dans laquelle est engagé et supporté un tube 7 ayant une disposition coaxiale par rapport au tube réacteur 1, par l'intermédiaire duquel des gaz réactifs peuvent être introduits à l'intérieur du tube réacteur 1. Le tube 7 est prolongé par un embout 39 venant coiffer une extrémité du tube de gainage 2, de telle manière que les gaz réactifs amenés par le tube 7 ne sont libérés dans le tube réacteur 1 qu'à proximité immédiate du substrat 2.

Le tube réacteur 1 est entouré par un four 8 ayant la forme d'un manchon qui est engagé sur le tube réacteur dans la zone dans laquelle est disposé le tube de gainage 2 maintenu par le support 3.

Le four 8 ayant la forme d'un manchon comporte, suivant une partie substantielle de sa longueur, des résistances électriques 9 noyées dans un matériau réfractaire d'isolation 10.

Le four permet d'assurer l'élévation et le maintien en température du tube réacteur 1, des gaz contenus à l'intérieur du tube réacteur et du tube de gainage 2 pendant les phases successives d'une opération de revêtement.

Le volume intérieur du tube réacteur 1 qui est relié par l'intermédiaire d'une conduite d'aspiration 11 et de deux conduites d'aspiration en dérivation 11a et 11b, à deux pompes à vide 12a et 12b peut être mis sous une pression réduite permettant d'obtenir des conditions optimales pour la réalisation des opérations de revêtement.

La pompe 12a est une pompe primaire à palette pouvant créer et maintenir un niveau de vide dans le tube réacteur tel que la pression résiduelle des gaz dans le tube réacteur puisse descendre jusqu'à 0,01 mbar.

La pompe 12 b est une pompe primaire à anneau liquide qui permet d'obtenir un vide tel que la pression résiduelle dans le tube réacteur puisse atteindre une valeur réduite pouvant aller jusqu'à 1 mbar.

La pompe 12a ou la pompe 12b peuvent être mises en communication avec le volume intérieur du four par ouverture de l'une des deux vannes 13a et 13b placées respectivement sur les conduites en dérivation 11a et 11b.

Un manomètre 14 permet de mesurer la pression à l'intérieur du tube réacteur 1.

Le tube réacteur 1 comporte une partie d'extrémité opposée à la platine 5 qui est mise en communication avec une chambre de chloration 15 placée dans une disposition latérale par rapport à la chambre du tube réacteur 1.

Autour de la partie du tube réacteur 1 comprise entre le chlorureur et le four et de la chambre de chloration 15 est disposée une bande chauffante électrique 16 permettant d'élever la température du tube réacteur 1 où transite l'halogénure métallique de manière à éviter sa condensation et de la chambre de chloration 15 et de maintenir cette température à un niveau déterminé.

La chambre de chloration 15 a été représentée de manière plus détaillée et en coupe sur la figure 1A.

La chambre de chloration 15 renferme un lit 17 en laine de quartz sur lequel est déposée une couche 18 de zirconium sous forme divisée, par exemple du zirconium sous forme de copeaux ou sous forme d'éponge.

Une conduite d'arrivée de gaz réactifs 19 débouche à la partie supérieure de la chambre de chloration 15 qui comporte une ouverture 20 à sa partie inférieure pour assurer la sortie d'un composé volatil de zirconium formé à l'intérieur de l'enceinte de chloration 15, par mise en contact des gaz réactifs pénétrant par la canalisation 19, avec le zirconium sous forme divisée de la couche 18.

La couche 18 de zirconium et le lit de laine de quartz 17 sont poreux et permettent le passage des gaz qui pénètrent dans le volume intérieur du tube réacteur 1, par l'ouverture 20.

Un thermocouple 21 disposé à l'intérieur d'un tube plongeur permet de repérer la température de la couche 18 de zirconium sous forme divisée qui est mise en contact avec les gaz réactifs.

La conduite 19 est reliée à son extrémité opposée à la chambre de chloration 15, à un panneau 22 de distribution de gaz permettant d'envoyer à l'intérieur de la canalisation 19 et de la chambre de chloration 15, un mélange gazeux parfaitement dosé comportant un halogénure tel que le chlore et un gaz inerte diluant tel que l'argon.

Le panneau de distribution 22 comporte une ligne d'alimentation en chlore 23 et une ligne d'alimentation en argon 24 disposées en parallèle et reliées à une extrémité de sortie, à la partie d'extrémité de la canalisation d'alimentation 19, par l'intermédiaire d'un raccord en Té 28 assurant le mélange du chlore et de l'argon.

Des vannes d'arrêt pneumatiques 25 et 25' sont disposées sur la canalisation 19, de manière à commander l'arrivée des gaz réactifs dans la chambre de chloration 15 ou au contraire à interrompre l'alimentation de la chambre de chloration en gaz réactif.

Chacune des lignes d'alimentation 23 et 24 qui est reliée à son extrémité opposée à la conduite d'alimentation 19 à un réservoir de stockage de gaz, ce gaz étant du chlore dans le cas de la ligne d'alimentation 23 et de l'argon dans le cas de la ligne d'alimentation 24, comporte un détendeur 26 et un débitmètre ou régulateur de débit massique 27 réalisant un dosage des gaz constitués par l'halogène et le gaz inerte, dans une proportion voulue parfaitement déterminée.

La conduite d'alimentation 19 reliée au mélangeur 28 permet d'envoyer dans la chambre de chloration 15 un mélange gazeux ayant une composition parfaitement définie.

La conduite 7 d'alimentation de la chambre du tube réacteur 1 en gaz réactif qui est reliée à l'embout d'injection 39 situé dans le tube réacteur 1 à l'une de ses extrémités est raccordée à son extrémité opposée à un second panneau d'alimentation 29 en gaz réactif, par l'intermédiaire d'au moins deux conduites d'alimentation en dérivation telles que les conduites 30 et 31.

Les conduites 30 et 31 sont reliées entre elles et à la conduite 7 par l'intermédiaire d'un raccord en Té 32 qui assure le mélange des gaz fournis par les conduites 30 et 31 pour réaliser un mélange réactif gazeux qui est introduit dans le volume intérieur du tube réacteur 1.

Chacune des conduites d'alimentation telles que 30 et 31 est reliée à une extrémité à un réservoir de stockage d'un gaz sous pression qui peut être soit un gaz réactif oxydant ou réducteur, soit un gaz inerte tel que l'argon.

Le gaz réactif oxydant peut être constitué par de l'oxygène pur, du dioxyde de carbone $CO_2$ ou encore de la vapeur d'eau.

Le gaz réactif réducteur peut être constitué par de l'hydrogène.

Sur chacune des conduites d'alimentation telles que 30 et 31 est disposé sur le panneau 29, en aval du réservoir, un détendeur 33 permettant d'abaisser et de régler la pression du gaz fourni par le réservoir de stockage de gaz et un débitmètre ou régulateur de débit massique 34 permettant de régler la proportion des différents gaz dans le mélange.

Une vanne d'isolation 35 est placée sur chacune des conduites 30 et 31 en amont du raccord 32.

Sur la conduite d'alimentation 7 reliée à l'embout d'injection 39 situé dans le tube réacteur 1 sont disposées, à l'extrémité de la conduite 7 reliée au raccord 32, une vanne d'isolation 36 et une électrovanne 37. Un manomètre 38 permet de mesurer la pression du mélange gazeux sortant du raccord 32.

La conduite d'alimentation 7 qui traverse la structure d'excitation 40 constituée par une cavité résonante reliée par un guide d'onde à un générateur de micro-ondes sert de tube à décharge.

Le mélange gazeux sortant du raccord 32 traverse le tube à décharge 7 qui réalise l'excitation du mélange gazeux par l'intermédiaire des micro-ondes transmises au tube à décharge 7 par la structure d'excitation 40. Dans le tube à décharge 7, le mélange gazeux est excité par absorption de l'énergie des micro-ondes ; de ce fait, le mélange gazeux sortant du tube à décharge 7 renferme des espèces excitées. Les espèces activées, électriquement neutres métastables, réagissent sur le substrat 2 en post-décharge en écoulement.

Un manomètre 41 permet de mesurer la pression du mélange gazeux à la sortie du tube à décharge relié au générateur de micro-ondes.

On peut ainsi faire pénétrer dans le tube réacteur, un mélange réactif gazeux comportant des espèces excitées et renfermant en particulier de l'oxygène, un gaz de support inerte et éventuellement un réducteur tel que l'hydrogène.

Une ligne 45 d'alimentation en gaz inerte tel que l'argon est de plus reliée directement au tube réacteur 1. Sur la ligne d'alimentation 45 qui est reliée à un réservoir d'argon à son extrémité opposée au tube réacteur 1, sont placés successivement un détendeur 43, un débitmètre massique 44 et une vanne 42. La ligne 45 permet d'introduire dans le tube réacteur 1 de l'argon d'appoint et d'entraînement des gaz dans le tube réacteur 1 à une vitesse réglée.

On va maintenant décrire la mise en oeuvre de l'installation pour la réalisation d'un revêtement de zircone sur un tube de gainage d'un assemblage de combustible nucléaire.

Le procédé de revêtement selon l'invention est un procédé en deux phases qui sont réalisées l'une à la suite de l'autre sur l'installation représentée sur les figures 1 et 1A.

Le tube de gainage 2 est mis en place à l'intérieur du tube réacteur 1 sur le support 3 qui est fixé sur le tube réacteur 1 par l'intermédiaire de la platine 5 rapportée de manière étanche sur le tube réacteur 1.

Pour réaliser la première phase du procédé de revêtement qui est une phase de préoxydation de la surface extérieure du tube 2 à l'aide d'un mélange d'oxygène et d'un gaz porteur inerte, on met en fonctionnement la pompe à vide 12b de manière à évacuer l'air contenu dans le tube réacteur 1. La vanne 13a est fermée et la vanne 13b est ouverte. On réalise un chauffage du tube de gainage par l'intermédiaire du four 8 à une température inférieure à 500°C et qui peut être comprise de préférence entre 250 et 480°C.

On alimente la conduite 7 en un mélange d'oxygène et de gaz inerte tel que l'argon, par l'intermédiaire des conduites 30 et 31 et du raccord mélangeur 32, de manière que le mélange gazeux formé pénètre dans l'embout d'injection 39 situé dans le tube réacteur 1 sous pression réduite.

On réalise le réglage des débits respectifs d'argon et d'oxygène par l'intermédiaire des débitmètres 34.

Le mélange gazeux traverse le tube à décharge 7 et la structure d'excitation 40 qui est reliée par un guide d'onde au générateur micro-ondes alimenté pour produire des micro-ondes d'une fréquence de 2450 MHz, qui transmet une énergie au mélange gazeux d'argon et d'oxygène. Le mélange introduit dans le tube réacteur 1 via l'embout d'injection 39 est ainsi excité, de sorte qu'on obtient rapidement une couche oxydée sur la surface du tube de gainage, à une température relativement basse.

Le mélange gazeux servant à la préoxydation est introduit dans le tube réacteur 1 à une pression réduite comprise entre 1 et 100 mbar. Dans ces conditions, la couche préoxydée peut atteindre une épaisseur de 0,1 à 1 µm en une durée d'une heure, suivant la température du substrat et du gaz réactif et la pression du gaz réactif.

La couche de préoxyde réalisée est très adhérente très peu poreuse et suffisamment couvrante pour protéger le substrat en alliage de zirconium pendant les phases ultérieures du procédé de revêtement et de l'exploitation du crayon combustible.

De manière préférentielle, on utilise une température de préoxydation de 460°C et un mélange d'argon et d'oxygène comportant 1 % d'oxygène en volume.

La seconde phase du procédé qui consiste à réaliser un dépôt de zircone sur la surface préoxydée peut être réalisée immédiatement après la phase de préoxydation ou de manière différée.

Il peut être avantageux de réaliser la phase de dépôt de zircone immédiatement après la phase de préoxydation, dans la mesure où le substrat constitué par le tube de gainage peut être maintenu à la température atteinte pendant la phase de préoxydation.

Pour réaliser le dépôt chimique en phase gazeuse de zircone sur la surface préoxydée du tube de gainage 2, on introduit dans la chambre de chloration 15 qui contient une couche 18 de zirconium sous forme divisée, un gaz réactif constitué par un mélange de chlore et d'argon provenant du panneau de distribution 22, par l'intermédiaire de la conduite d'alimentation 19.

La couche 18 de zirconium sous forme divisée est chauffée à une température de réaction comprise entre 160 et 350°C. Le mélange gazeux d'argon et de chlore est introduit dans la chambre de chloration 15, de manière à venir en contact avec le zirconium sous forme divisée constituant la couche 18.

Au contact du chlore, le zirconium se transforme en chlorure de zirconium $ZrCl_4$ suivant la réaction :

$$2Cl_2 + Zr \rightarrow ZrCl_4.$$

De préférence, le mélange de chlore et d'argon est introduit dans la chambre de chloration 15 à une température de 300°C et à une pression de 20 mbar.

Le chlorure de zirconium $ZrCl_4$ obtenu sous forme gazeuse traverse le lit de laine de quartz 17 pour pénétrer dans la chambre du tube réacteur 1.

A l'intérieur de la chambre du tube réacteur 1, on réalise l'oxydation du chlorure de zirconium $ZrCl_4$ en zircone $ZrO_2$ en utilisant un mélange réactif comportant au moins un gaz oxydant et un gaz inerte et de préférence un gaz oxydant, un gaz réducteur et un gaz inerte.

Le mélange de gaz réactifs est excité dans le tube à décharge 7, par l'énergie des micro-ondes produites par le générateur de micro-ondes et transférées jusqu'à la structure d'excitation 40.

Le chlorure de zirconium gazeux fourni en sortie de la chambre de chloration 15 est tenu séparé du mélange oxydant provenant du plasma grâce au tube d'injection 39 en quartz, de manière à éviter qu'il ne réagisse en phase homogène et ne soit totalement consommé avant d'avoir atteint le substrat. Le mélange du chlorure gazeux et du gaz oxydant activé n'est donc réalisé qu'au voisinage le plus immédiat du substrat 2.

Cette séparation permet, de surcroît, de transporter les gaz sur une distance telle qu'elle évite de positionner le substrat en proche post-décharge.

Du fait de l'absence d'électrons ou d'ions dans le mélange gazeux et de la nécessité de traiter des pièces de grande longueur, on doit exploiter la lointaine post-décharge. Par ailleurs, la possibilité de choix de la distance décharge/zone de réaction permet d'adapter la réactivité du mélange gazeux et donc par exemple de préférer le contrôle de la réaction par un régime chimique ou diffusionnel. Enfin, cette configuration permet d'éviter les problèmes d'écoulement qui pourraient nécessiter de rajouter une source d'activation complémentaire, telle qu'un faisceau d'ions.

Les gaz réactifs sont à une température de réaction comprise entre 250 et 500°C. La pression de ces gaz est comprise entre 1 et 100 mbars.

De préférence, on utilise un mélange gazeux réactif renfermant de l'oxygène, de l'hydrogène et de l'argon.

Un tel mélange activé venant en contact avec le chlorure de zirconium $ZrCl_4$ sous forme gazeuse produit une oxydation du chlorure qui se transforme en zircone et libère l'élément chlore.

L'adhérence de la couche de zircone est facilitée par la présence d'une couche préoxydée sur la surface du tube de gainage. En effet, la couche préoxydée imperméable aux gaz s'oppose à une attaque du métal du substrat par l'hydrogène et les chlorures ou le chlore produit. L'hydrogène et le chlore ont tendance à se combiner pour être éliminés sous forme de composés tels que HCl dans les gaz aspirés par la pompe à la sortie du tube réacteur.

L'oxydation du tétrachlorure de zirconium $ZrCl_4$ est réalisée par les espèces excitées du mélange $O_2$-$H_2$-Ar présentes en post-décharge.

Cette oxydation peut être réalisée à une température modérée par exemple comprise entre 250 et 500°C ou, de manière plus précise, entre 300 et 480°C. La cinétique de croissance de la couche de zircone peut dépasser 30 µm/h.

On a également proposé d'utiliser des mélanges ternaires comportant un élément oxydant différent de l'oxygène pur et par exemple un élément oxydant constitué par du dioxyde de carbone $CO_2$.

Les dépôts de zircone obtenus par le procédé de l'invention sont très adhérents et peuvent atteindre des épaisseurs relativement élevées de l'ordre de 20 à 60 µm pour des durées de traitement limitées à deux heures.

La zircone déposée présente une structure cristallographique monoclinique.

Des essais de rayure ont été effectués sur le revêtement de zircone déposée sur un tube en Zircaloy 4. Ces essais ont montré que le revêtement présente un caractère ductile lors des essais de rayure, ce qui peut être attribué à une structure colonnaire des revêtements réalisés.

Les revêtements réalisés sont susceptibles d'apporter une protection efficace aux tubes de gainage en alliage de zirconium, vis-à-vis des agressions mécaniques telles que les rayures ou l'usure.

L'invention ne se limite pas aux modes de réalisation qui ont été décrits.

C'est ainsi qu'on peut réaliser la couche pré-oxydée et le dépôt de zircone d'une manière différente de celle qui a été décrite, à partir de mélanges gazeux excités différents de ceux qui ont été indiqués.

Le dépôt de zircone peut être réalisé à partir d'un halogénure de zirconium différent d'un chlorure.

L'invention s'applique également à la protection de métaux passivables différents du zirconium et de ses alliages et par exemple à la protection du hafnium.

Le dispositif utilisé pour réaliser les deux phases successives du revêtement peut présenter des caractéristiques différentes de celles qui ont été décrites.

Les moyens de chauffage du substrat et des gaz utilisés peuvent être différents des moyens de chauffage électriques qui ont été décrits.

Les moyens de distribution des gaz peuvent également être différents.

Le réacteur dans lequel est disposé le substrat à revêtir peut présenter une forme différente d'une forme tubulaire, cette forme étant adaptée à la forme de la pièce à revêtir.

De manière à rendre plus homogène le dépôt de zircone sur la surface extérieure d'un tube, il est possible de mettre le tube en rotation autour de son axe à l'intérieur du réacteur pendant le dépôt en phase vapeur de l'oxyde de protection.

Le procédé suivant l'invention s'applique non seulement au revêtement de tubes de gainage pour crayons de combustible nucléaire mais également à d'autres éléments pour assemblages de combustible nucléaire généralement réalisés en un métal passivable tel que le zirconium et ses alliages.

En particulier, le procédé suivant l'invention peut être utilisé pour réaliser un revêtement anti-usure et anti-rayure des grilles d'assemblages combustibles en alliage de zirconium.

Une application particulière de l'invention est relative à la réalisation de revêtements contre l'usure à l'intérieur de tubes-guides d'assemblages de combustible assurant le guidage de crayons absorbant les neutrons des grappes de réglage de la réactivité du coeur du réacteur nucléaire. On limite ainsi les risques d'usure résultant des vibrations des parties d'extrémité des crayons absorbants des grappes de réglage, notamment lorsque la grappe est en position extraite, de telle sorte que les parties d'extrémité inférieures des crayons absorbants vibrent dans la partie supérieure des tubes de guidage de grappes. Le revêtement réalisé peut recouvrir tout ou partie de la surface interne du tube de guidage.

## Revendications

1.   Procédé de revêtement d'un substrat (2) en un métal passivable ou un alliage à base d'un métal passivable tel que le zirconium, par une couche d'oxyde métallique, caractérisé par le fait :

- qu'on réalise une préoxydation superficielle du substrat (2) par mise en contact, avec un gaz oxydant excité dans un plasma froid, du substrat (2) placé dans la post-décharge en écoulement du plasma et porté à une température d'oxydation inférieure à 500°, et
- on réalise sur le substrat placé dans la post-décharge en écoulement du plasma, un dépôt d'oxyde métallique par oxydation d'un halogénure métallique, en mettant en contact l'halogénure métallique sous forme gazeuse avec un mélange gazeux réactif comportant un élément oxydant excité dans un plasma froid.

2. Procédé suivant la revendication 1, caractérisé par le fait qu'on élabore l'halogénure métallique gazeux par réaction d'un halogène sur un métal (18) sous forme divisée porté à une température de réaction déterminée.

3. Procédé suivant l'une quelconque des revendications 1 et 2, caractérisé par le fait que le substrat (2) est disposé dans la lointaine post-décharge en écoulement du plasma froid.

4. Procédé suivant l'une quelconque des revendications 1 à 3, caractérisé par le fait que le plasma froid est produit par des micro-ondes.

5. Procédé suivant l'une quelconque des revendications 1 à 4, caractérisé par le fait que le mélange gazeux d'oxydation de l'halogénure comporte un composant oxydant, un composant réducteur et un gaz inerte.

6. Procédé suivant la revendication 5, caractérisé par le fait que le composant oxydant est constitué par de l'oxygène pur, le composant réducteur par de l'hydrogène et le gaz inerte par de l'argon.

7. Procédé suivant la revendication 6, caractérisé par le fait que le substrat (2) et le mélange gazeux d'oxydation de l'halogénure sont portés à une température de réaction comprise entre 250 et 500°C.

8. Procédé suivant l'une quelconque des revendications 1 à 7, caractérisé par le fait que, pendant la phase de préoxydation, le gaz oxydant mis en contact avec le substrat (2) est constitué par de l'oxygène mélangé à de l'argon.

9. Procédé suivant la revendication 8, caractérisé par le fait que la température du substrat et du gaz oxydant pendant la phase de préoxydation est comprise entre 250 et 500°C.

10. Procédé suivant l'une quelconque des revendications 1 à 9, caractérisé par le fait que le substrat est constitué par un alliage de zirconium et que l'oxyde déposé sur le substrat (2) est constitué par de la zircone $ZrO_2$.

11. Procédé suivant la revendication 2, caractérisé par le fait qu'on fait réagir sur du zirconium sous forme divisée porté à une température comprise entre 160 et 350°C, un gaz contenant du chlore, pour obtenir du tétrachlorure de zirconium $ZrCl_4$ sous forme gazeuse.

12. Procédé suivant la revendication 11, caractérisé par le fait que le gaz contenant du chlore est un mélange de chlore et d'argon et que la température du zirconium (18) sous forme divisée et du mélange gazeux est voisine de 300C°.

**Patentansprüche**

1. Verfahren zur Beschichtung eines Substrats (2) aus einem passivierbaren Metall oder einer Legierung auf der Basis eines passivierbaren Metalls wie Zirconium mit einer Schicht aus einem Metalloxid, dadurch gekennzeichnet, daß

- eine Voroxidation der Oberfläche des Substrats (2) durchgeführt wird, indem das Substrat (2), das im Nachglühbereich im Plasmastrom angeordnet ist und auf eine Oxidationstemperatur unter 500 °C gebracht ist, mit einem angeregten oxidierenden Gas in einem kalten Plasma in Kontakt gebracht wird, und
- auf dem Substrat, das im Nachglühbereich im Plasma strom angeordnet ist, ein Überzug aus einem Metalloxid durch Oxidation eines Metallhalogenids erzeugt wird, indem das gasförmig vorliegende Metallhalogenid mit einem reaktiven gasförmigen Gemisch, das einen angeregten oxidierenden Bestandteil in einem kalten Plasma enthält, in Kontakt gebracht wird.

2. Verfahren nach Anspruch 1, dadurch gekennzeichnet, daß das gasförmige Metallhalogenid durch Umsetzung eines Halogens mit einem in zerteilter Form vorliegenden Metall (18), das auf eine festgelegte Temperatur gebracht worden ist, erzeugt wird.

3. Verfahren nach einem der Ansprüche 1 und 2, dadurch gekennzeichnet, daß das Substrat (2) im fernen Nachglühbereich im Strom des kalten Plasmas angeordnet ist.

4. Verfahren nach einem der Ansprüche 1 bis 3, dadurch gekennzeichnet, daß das kalte Plasma mit Mikrowellen erzeugt wird.

5. Verfahren nach einem der Ansprüche 1 bis 4, dadurch gekennzeichnet, daß das gasförmige Gemisch für die Oxidation des Halogenids einen oxidierenden Bestandteil, einen reduzierenden Bestandteil und ein Inertgas enthält.

6. Verfahren nach Anspruch 5, dadurch gekennzeichnet, daß der oxidierende Bestandteil aus reinem Sauerstoff, der reduzierende Bestandteil aus Wasserstoff und das Inertgas aus Argon besteht.

7. Verfahren nach Anspruch 6, dadurch gekennzeichnet, daß das Substrat (2) und das gasförmige Gemisch für die Oxidation des Halogenids auf eine Reaktionstemperatur von 250 bis 500 °C gebracht werden.

8. Verfahren nach einem der Ansprüche 1 bis 7, dadurch gekennzeichnet, daß während der Voroxidationsphase das oxidierende Gas, das mit dem Substrat (2) in Kontakt gebracht wird, aus Sauerstoff, der mit Argon vermischt ist, besteht.

9. Verfahren nach Anspruch 8, dadurch gekennzeichnet, daß die Temperatur des Substrats und des oxidierenden Gases während der Voroxidationsphase 250 bis 500 °C beträgt.

10. Verfahren nach einem der Ansprüche 1 bis 9, dadurch gekennzeichnet, daß der Träger aus einer Zirconium-Legierung besteht und daß das Oxid, das auf dem Substrat (2) abgeschieden wird, aus Zirconiumdioxid $ZrO_2$ besteht.

11. Verfahren nach Anspruch 2, dadurch gekennzeichnet, daß in zerteilter Form vorliegendes Zirconium, das auf eine Temperatur von 160 bis 350 °C gebracht wird, mit einem Gas zur Reaktion gebracht wird, das Chlor enthält, um gasförmiges Zirconiumtetrachlorid $ZrCl_4$ zu erzeugen.

12. Verfahren nach Anspruch 11, dadurch gekennzeichnet, daß das Gas, das Chlor enthält, ein Gemisch aus Chlor und Argon ist und daß die Temperatur des in zerteilter Form vorliegenden Zirconiums (18) und des gasförmigen Gemischs etwa 300 °C beträgt.

**Claims**

1. Process for coating a substrate (2) of a passivatable metal or an alloy based on a passivatable metal such as zirconium, with a metal oxide layer, characterised in that:

   surface pre-oxidation of the substrate (2) is carried out by bringing the substrate (2), placed in the plasma flow post-discharge and heated to an oxidation temperature of below 500°C, into contact with an excited oxidising gas in a cold plasma, and
   a metal oxide deposit is formed on the substrate placed in the plasma flow post-discharge by oxidation of a metal halide, by bringing the metal halide, in gaseous form, into contact with a reactive gas mixture comprising an excited oxidising element in a cold plasma.

2. Process according to claim 1, characterised in that the gaseous metal halide is produced by reacting a halogen with a metal (18) in divided form heated to a specified reaction temperature.

3. Process according to one of claims 1 and 2, characterised in that the substrate (2) is placed in the cold plasma flow at a distance from the discharge.

4. Process according to any one of claims 1 to 3, characterised in that the cold plasma is produced by microwaves.

5. Process according to any one of claims 1 to 4, characterised in that the gaseous oxidation mixture of the halide comprises an oxidising component, a reducing component and an inert gas.

6. Process according to claim 5, characterised in that the oxidising component consists of pure oxygen, the reducing component consists of hydrogen and the inert gas consists of argon.

7. Process according to claim 6, characterised in that the substrate (2) and the gaseous oxidation mixture of the halide are heated to a reaction temperature between 250 and 500°C.

8. Process according to one of claims 1 to 7, characterised in that during the pre-oxidation phase the oxidising gas brought into contact with the substrate (2) consists of oxygen mixed with argon.

9. Process according to claim 8, characterised in that the temperature of the substrate and the oxidising gas during the pre-oxidation phase is between 250 and 500°C.

10. Process according to any one of claims 1 to 9, characterised in that the substrate consists of a zirconium alloy and the oxide deposited on the substrate (2) consists of zircon $ZrO_2$.

11. Process according to claim 2, characterised in that zirconium in divided form heated to a temperature of between 160 and 350°C is reacted with a gas containing chlorine, to obtain zirconium tetrachloride $ZrCl_4$ in gaseous form.

12. Process according to claim 11, characterised in that the gas containing chlorine is a mixture of chlorine and argon and the temperature of the zirconium (18) in divided form and the gaseous mixture is approximately 300°C.

FIG.1

FIG.1A

EP 0 795 042 B1